# EUROPEAN PATENT APPLICATION

(11) **EP 1 786 110 A1**
(43) Date of publication of application: **16.05.2007**
(21) Application number: 05776930.9
(22) Date of filing: 29.08.2005
(51) Int. Cl.: H04B 1/06, H03J 7/18, H04N 5/44

(54) **BROADCASTING RECEIVER**

(30) Priority: 01.09.2004 JP 2004254130
(71) Applicant: FUJITSU TEN LIMITED, Kobe-shi Hyogo 652-8510 (JP)
(72) Inventor: OTA, Satoshi, FUJITSU TEN LIMITED, Hyogo-ku, Kobe-shi, Hyogo 6528510 (JP); MIYANO, Kazuhiko, FUJITSU TEN LIMITED, Hyogo-ku, Kobe-shi, Hyogo 6528510 (JP)
(74) Representative: Skone James, Robert Edmund
(86) International application number: PCT/JP2005/016161
(87) International publication number: WO 2006/025544

(57) **Abstract**

A digital broadcast receiving apparatus provided with a user friendly automatic channel selection function is provided.

An automatic channel selection function unit 11 operating under a plurality of channel selection modes is provided. As this plurality of channel selection modes, a first channel selection mode (11-1) of searching only for broadcast stations and further a second channel selection mode (11-2) of additionally searching for service IDs provided by the broadcast station are included.

## Description

### TECHNICAL FIELD

The present invention relates to a broadcast receiving apparatus, particularly a digital broadcast receiving apparatus, more specifically a digital broadcast receiving apparatus provided with an automatic channel selection function unit.

### BACKGROUND ART

The automatic channel selection function unit, as is well known, plays an important role in "search" processing and "auto preset" processing. Here, this "search" processing means for example processing successively searching for broadcasts receivable in a current location by operation of an up/down button. By repeating this search, it is possible to select a good reception condition broadcast preferred by the user. This is one function of automatic channel selection.

Another function of automatic channel selection is the "auto preset". Here, "auto preset" processing means to search for and store broadcasts receivable at a current location as explained above and to successively assign good reception condition, favorite broadcasts to preset buttons.

The above-mentioned automatic channel selection is processing particularly essential for car-mounted broadcast receiving apparatuses where the current location is constantly changing and has been long been provided in almost all car-mounted analog broadcast receiving apparatuses.

On the other hand, in digital broadcast receiving apparatuses, which will rapidly spread and take the place of analog broadcast receiving apparatuses in the future, the above automatic channel selection function will be an essential component. The present invention, as explained above, provides an automatic channel selection function for a user friendly digital broadcast receiving apparatus.

Note that as known documents related to the present invention, for example, there are the following [Patent Document 1] to [Patent Document 5].

[Patent Document 1] assigns a preset button just a receivable, low error rate ensemble (transport stream) service,
[Patent Document 2] provides as the preset button a one-touch search button which designates a search condition (genre) preferred by the user such as for example "soccer", and
[Patent Document 3] searches for a channel to which the designated genre is added and displays the search results after removing from the search results any channel stored in a preset memory and thereby enables the number of channel selection operations to be reduced.

Further, [Patent Document 4] enables the same program to be received by content registered for the same preset key by use of a program ID as registered information in a preset memory even if the broadcast station side changes the channel number, and
[Patent Document 5] stores an optimum frequency at which a synchronization signal is detected at the time of auto preset and enables a synchronization signal to be quickly detected based on stored frequency information when selecting a channel.

[Patent Document 1] Japanese Patent Publication (A) No. 2002-26755
[Patent Document 2] Japanese Patent Publication (A) No. 2003-153104
[Patent Document 3] Japanese Patent Publication (A) No. 2002-51277
[Patent Document 4] Japanese Patent Publication (A) No. 2003-101425
[Patent Document 5] Japanese Patent Publication (A) No. 2001-309259

### DISCLOSURE OF THE INVENTION

### PROBLEM TO BE SOLVED BY THE INVENTION

The means for realizing above-mentioned automatic channel selection have already been established in analog broadcast receiving apparatuses. The established means for realizing the automatic channel selection however cannot be used as is for digital broadcast receiving apparatuses. This is because the automatic channel selection in an analog broadcast receiving apparatus comprised the relatively simple mechanism of successively searching for broadcast stations and, when receivable, storing their frequencies in a memory.

However, in the case of digital broadcasts, in addition to the provision of video or audio information like in the case of the conventional analog broadcasts, it is also possible to provide detailed program information. This program information includes, for example, the program name, program genre, program content, program duration, etc. The user can select and enjoy a desired program from a large number of channels.

This being the case, the automatic channel selection function unit of a digital broadcast receiving apparatus has to be provided with not only the function of automatic channel selection for only broadcast stations, but also the function of automatic channel selection under the condition of service IDs (program information) added to the broadcast stations.

However, when obtaining the service IDs, it is necessary to go through the process of first examining a broadcast wave, decoding and then analyzing the data, then examining its service ID. For this reason, when running a search under the condition of service IDs added to the broadcast stations, the search time ends up becoming much longer compared with when running a search for only broadcast stations.

This being the case, users considering it unnecessary to identify the service IDs are kept needlessly waiting for a long search time. This automatic channel selection ends up becoming very user unfriendly. The user also is made to feel dissatisfied.

Therefore, the present invention, in consideration of the above problem, has as its object the realization of a digital broadcast receiving apparatus wherein a user friendly automatic channel selection function unit is realized.

### MEANS FOR SOLVING THE PROBLEMS

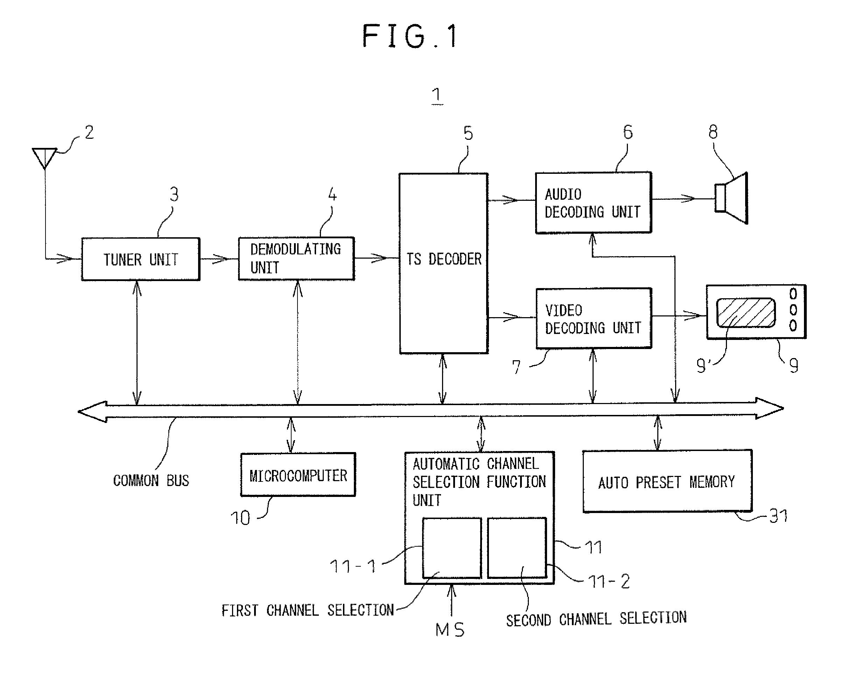

FIG. 1 is a basic view of the configuration of a digital broadcast receiving apparatus according to the present invention.

The broadcast receiving apparatus 1 shown in the figure is a broadcast receiving apparatus having an automatic channel selection function unit 11 for searching for broadcast waves received by an antenna 2. Here, the automatic channel selection function unit 11 can be set to a plurality of different channel selection modes and executes automatic channel selection by a channel selection mode selected by mode selection information MS from the user. Note that automatic channel selection function unit 11 can be actually be realized by software processing by a microcomputer 10, but in the present invention, for facilitating the explanation, this is expressed as an independent component element.

The channel selection modes more specifically include a first channel selection mode 11-1 and second channel selection mode 11-2. When the above broadcast waves are digital broadcasts, the first channel selection mode 11-1 is a channel selection mode for selecting only broadcast stations of digital broadcasts. Further, the second channel selection mode 11-2 is a channel selection mode for searching for not only broadcast stations of digital broadcasts, but also service IDs provided by such broadcast stations. The provision of these different types of channel selection modes (11-1, 11-2) is the basic characteristic of the present invention. The rest of the component elements 2, 3, 4, 5... are known. These known component elements will be briefly explained next.

A broadcast wave received by the antenna 2 is input to a first tuner unit 3. There, a broadcast wave (carrier) selected by the user or the automatic channel selection function unit 11 is input to the next demodulating unit 4 where it is demodulated to digital data.

The thus demodulated digital data is sent to a TS (Transport Stream) decoder 5 where it is separated into data forming the audio signal and data forming the video signal (if necessary further data including a broadcast markup language (BML) text). The audio data and video data separated here are converted by an audio decoding unit 6 and video decoding unit 7 to an analog audio signal and further converted to a predetermined format video signal. These are then output to the audio speaker 8 and video monitor 9. Reference numeral 9' is a screen.

### EFFECTS OF THE INVENTION

When the automatic channel selection function unit 11 in the broadcast receiving apparatus 1 successively searches for just receivable broadcast stations such as with a conventional analog broadcast receiving apparatus, even if detailed program information (service ID) is provided for digital broadcast receiving apparatuses, it cannot use it. Some users will therefore feel dissatisfied.

On the other hand, while a digital broadcast receiving apparatus provided with an automatic channel selection function unit able to use even the program information can use the detailed program information (service IDs), as already explained, each search is accompanied with a long waiting time. A user desiring a fast search comprising just a search of the names of the broadcast stations would therefore feel dissatisfied.

The present invention can eliminate the former dissatisfaction and the latter dissatisfaction described above all at once. That is, automatic channel selection can be realized able to satisfy both a user wanting the search to cover even detailed program information even if taking time and a user wanting the search to cover just the names of the broadcast stations in a hurry.

### BRIEF DESCRIPTION OF THE DRAWINGS

FIG. 1 is a basic view of the configuration of a broadcast receiving apparatus according to the present invention.
FIG. 2 is a view schematically showing an example of a first channel selection mode.
FIG. 3 is a view schematically showing a modification of a first channel selection mode.
FIG. 4 is a view for explaining a second channel selection mode.
FIG. 5 is a view schematically showing a second channel selection mode in the broadcast system of FIG. 4.
FIG. 6 is a view schematically showing an example of a second channel selection mode.
FIG. 7 is a view showing a discriminating means etc. added to the automatic channel selection function unit of FIG. 1.
FIG. 8 is a flowchart showing the basic operation at FIG. 7.
FIG. 9 is a flowchart based on a first input pattern in FIG. 7.
FIG. 10 is a flowchart based on a second input pattern in FIG. 7.
FIG. 11 is a flowchart based on a third input pattern in FIG. 7.

### BEST MODE FOR CARRYING OUT THE INVENTION

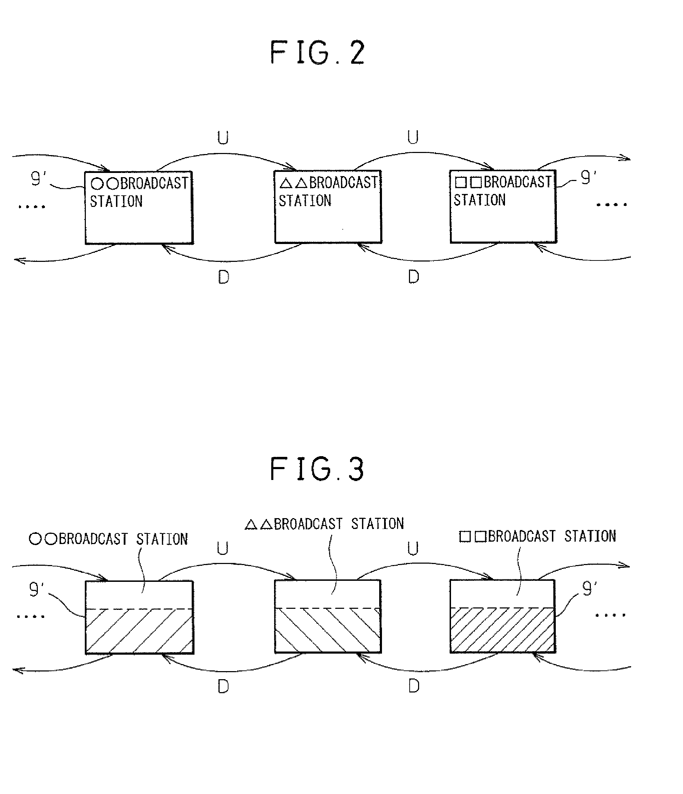

FIG. 2 is a view schematically showing an example of a first channel selection mode. In the figure, 9' is a screen of the above-mentioned monitor. By operation of a frequency up button (U) or operation of a down button (D), the names of the receivable broadcast stations are successively displayed.

FIG. 3 is a view schematically showing a modification of the first channel selection mode. In this modification of the first channel selection mode, the names of the broadcast stations are successively displayed and the broadcast programs for predetermined representative service IDs among a plurality of service IDs provided by each broadcast station are displayed.

In a digital broadcast, even the same broadcast station will offer a plurality of programs differentiated by a plurality of service IDs. In the case of FIG. 2, these broadcast programs are not displayed on the screen 9' at all, but in the case of FIG. 3, it is possible to display a broadcast program according to any single fixed service ID (shown by hatching). By doing this, it is possible to determine the quality of reception of a broadcast from that broadcast station.

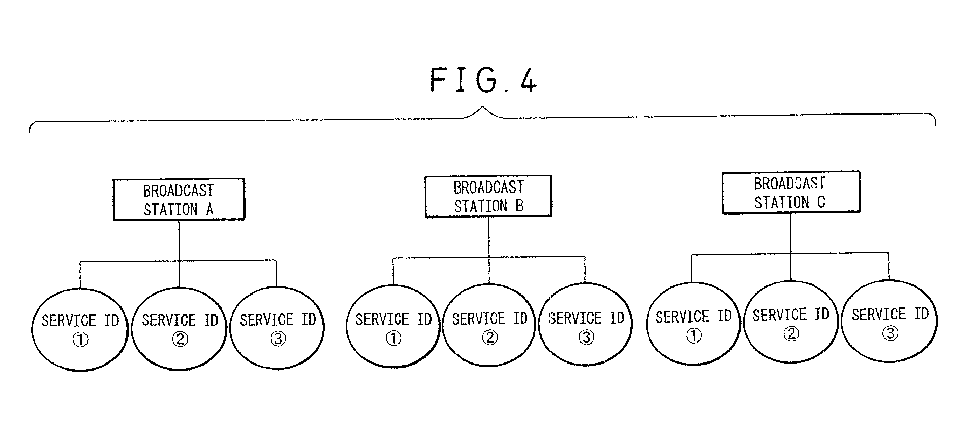

FIG. 4 is a view for explaining a second channel selection mode. According to the example of this figure, digital broadcasts are transmitted by three broadcast stations A, B, and C. Further, these broadcast stations A, B, and C transmit broadcasts relating to three service IDs.

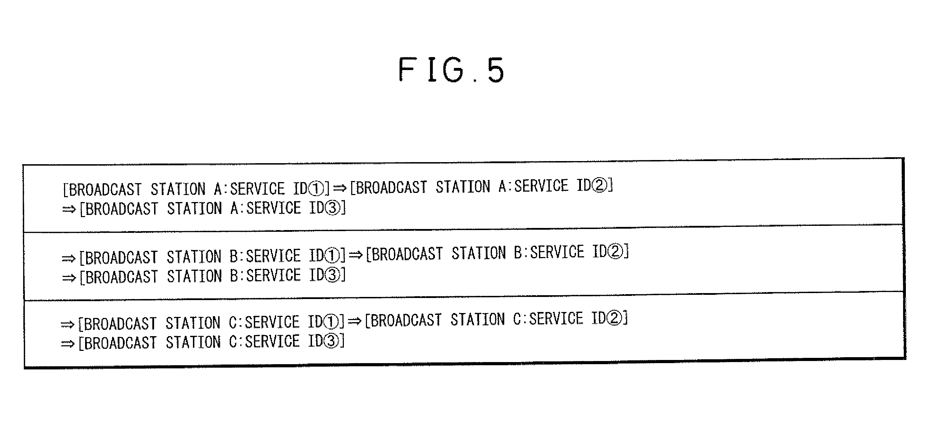

FIG. 5 is a view schematically showing the second channel selection mode under the broadcasting mode of FIG. 4. That is, in this second channel selection mode, the names of the broadcast stations are successively displayed and the plurality of service IDs provided by the broadcast stations are successively displayed for each of the successively displayed broadcast stations.

In this case, in the same way as explained in FIG. 3. it is possible to display the broadcast program of the first service ID provided by each broadcast station for each of the successively displayed broadcast stations.

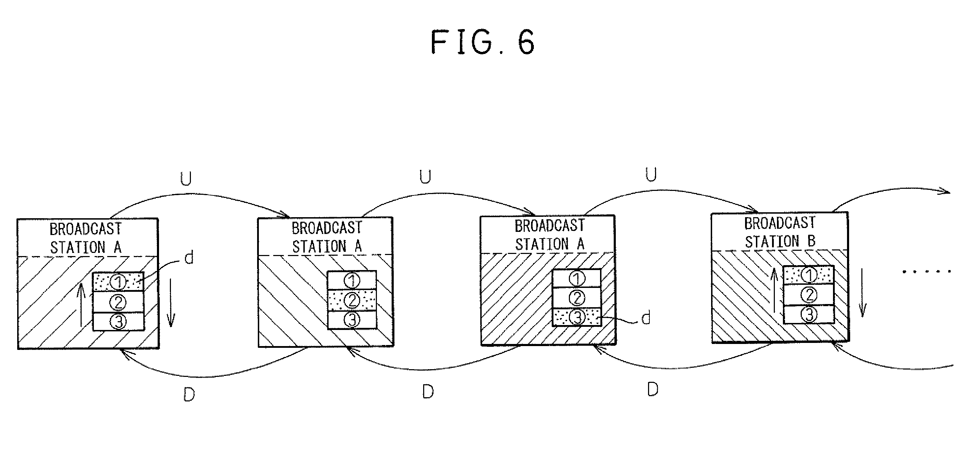

FIG. 6 is a view schematically showing an example of the second channel selection mode. In the second channel selection mode shown in this example, when successively displaying the names of the broadcast stations (A, B, C...) and successively displaying the plurality of service IDs (1, 2, 3...) provided by each broadcast station for each of the successively displayed broadcast stations, the broadcast program for each displayed service ID (shown by the dots d) is displayed (shown by hatching).

The component elements required when realizing the above-mentioned first channel selection mode and second channel selection mode will be explained below.

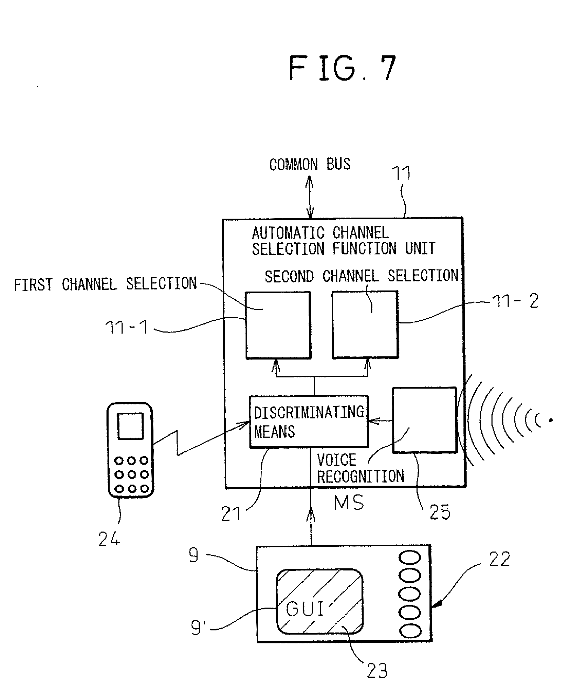

FIG. 7 is a view showing a discriminating means added to the automatic channel selection function unit of FIG. 1. Reference numeral 21 in the figure indicates a discriminating means. The automatic channel selection function unit 11 receives mode selection information MS from the user by this discriminating means 21 and discriminates which of the first channel selection mode (11-1) or second channel selection mode (11-2) has been selected.

Specifically, the discriminating means 21 discriminates the input pattern input by the user as the mode selection information MS such as a long/short push, single/double push, or first/second mode designation.

In this case, there is a mechanical switch 22 or GUI switch 23 on the screen 9' for a user to input mode selection information MS to the discriminating means 21.

Alternatively, it is possible to connect a remote control transmitter 24 for a user to remotely input the mode selection information MS to the discriminating means 21.

Further, it is also possible to provide a voice recognition means 25 enabling a user to input mode selection information MS to the discriminating means 21 by voice.

The operations of the present invention explained above may be expressed by a flowchart as follows.

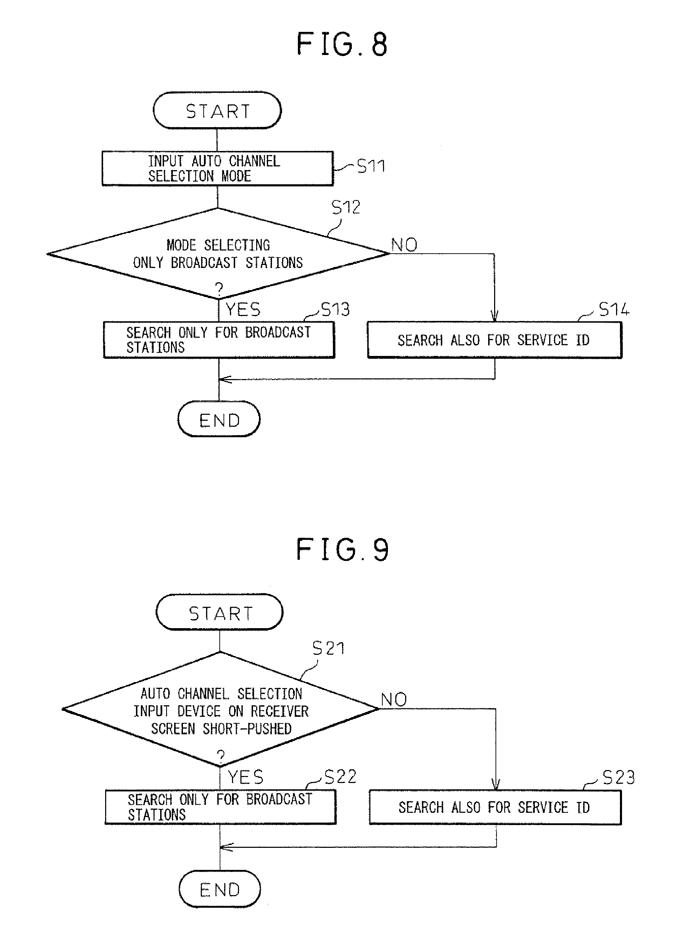

FIG. 8 is a flowchart of the basic operation in FIG. 7. In the flowchart,
Step S11: The user inputs an instruction to enter the auto channel selection mode.

Step S12: Whether the mode is the mode for selecting only broadcast stations (first channel selection mode) or not (second channel selection mode) is judged.

Step S13: In accordance with the YES at step S12, only broadcast stations are searched for. Alternatively,
Step S14: In accordance with the NO at step S12, the service IDs are also searched for.

FIG. 9 is a flowchart based on the first input pattern in FIG. 7,

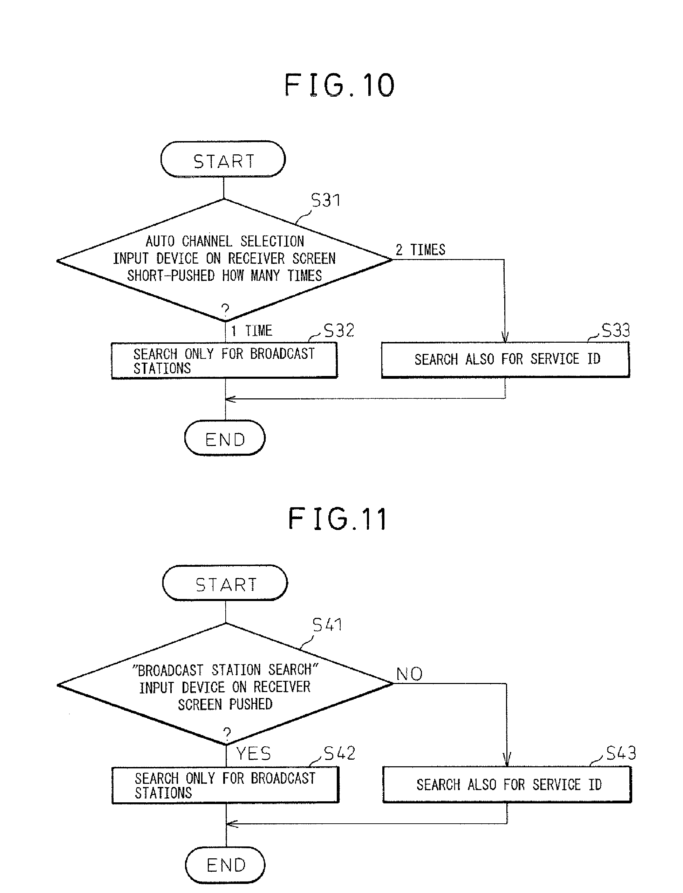

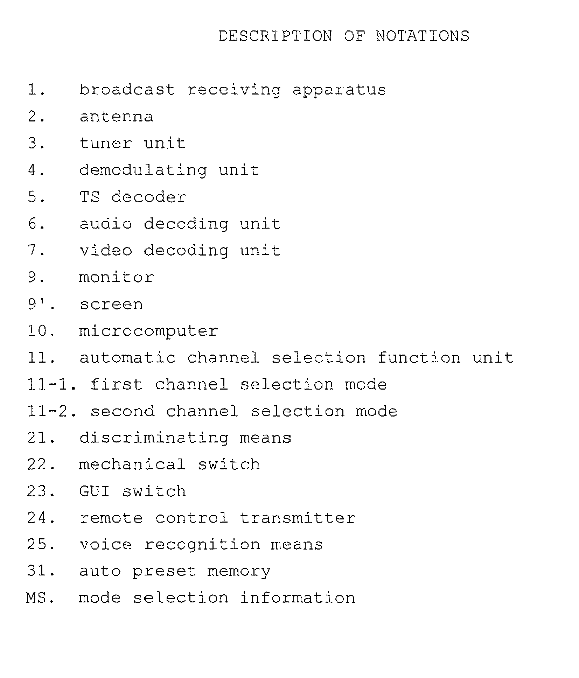

FIG. 10 is a flowchart based on the second input pattern in FIG. 7, and
FIG. 11 is a flowchart based on the third input pattern in FIG. 7.

As explained above, the discriminating means 21 discriminates the channel selection mode from the various input patterns input as mode selection information MS by the user, that is, a long/short push, single/double push, and first/second mode designation. These operations are shown in the flowcharts of FIG. 9, FIG. 10, and FIG. 11.

First, referring to FIG. 9,
Step S21: Whether the GUI switch (automatic channel selection use input device) 23 of the screen 9' of FIG. 7 (or an equivalent mechanical switch 22) has been short pushed or not (long pushed) is judged.

Step S22: In accordance with the YES of step S21 (short push), only the broadcast stations are searched for. Alternatively,
Step S23: In accordance with the NO at step S21 (long push), the service IDs are also searched for.

Next, referring to FIG. 10,
Step S31: How many times the GUI switch (automatic channel selection use input device) 23 of the screen 9' of FIG. 7 (or an equivalent mechanical switch 22) has been short pushed (long pushed) is judged.

Step S32: In accordance with the single short push of step S31, only the broadcast stations are searched for. Alternatively,
Step S33: In accordance with the double short push at step S31, the service IDs are also searched for.

Further, referring to FIG. 11,
Step S41: Whether the GUI switch (automatic channel selection use input device) 23 of the screen 9' of FIG. 7 (or an equivalent mechanical switch 22) has been pushed (first mode designation) or not (second mode designation) is judged.

Step S42: In accordance with the YES of step S41 (first mode designation), only the broadcast stations are searched for. Alternatively,
Step S43: In accordance with the NO of step S41 (second mode designation), the service IDs are also searched for.

Based on the above-explained "search" processing, the "auto preset" processing unique to the present invention can be performed. For this reason, a memory (HDD or nonvolatile memory) storing channel selection information (broadcast stations, service IDs, etc.) searched for under the first channel selection mode (11-1) and second channel selection mode (11-2) is provided. This is shown as the "auto preset" memory 31 in FIG. 1.

Using this auto preset memory 31, a third channel selection mode according to the present invention can be executed. This third channel selection mode is a combination of the already explained first channel selection mode and second channel selection mode. The second channel selection mode shown in FIG. 5 successively searches for all receivable broadcast stations and all service IDs provided by the broadcast stations. By doing this, everything would be stored, including broadcast stations unnecessary to the user and service IDs not favored by the user, which would be inefficient.

Therefore, when the required broadcast stations are retrieved, these are immediately stored in the auto preset memory 31. When service IDs favored by the users are retrieved, these are immediately stored in the auto preset memory 31.

In summary, the invention includes the third channel selection mode as one of the already mentioned plurality of channel selection modes. This third channel selection mode is comprised of the processing for searching for and registering only freely selected broadcast stations among the plurality of broadcast stations of digital broadcasts when the broadcast waves are digital broadcasts and processing for searching for and registering not only the broadcast stations but also the freely selected service IDs among the plurality of service IDs provided by the broadcast stations. The auto preset memory 31 stores the channel selection information searched for and registered under this third channel selection mode.

In each of the above first, second, and third channel selection modes, it is preferable that only channel selection information selected under specific conditions among the retrieved channel selection information be input to the auto preset memory 31. The first of these specific conditions is the "error rate at the time of reception". This error rate (BER) is monitored at the reception apparatus 1. The channel selection information is rearranged in the order of the frequency with the lowest error rate up and stored in the auto preset memory 31. Due to this, it is possible to provide the user with high quality broadcast programs at all times.

Further, the second of the specific conditions is to give priority to "frequency broadcasts over in common throughout the country" in the search. Due to this, it is possible to capture broadcast programs able to be received anywhere in a short time.

The third of the specific conditions is to discriminate "frequencies only broadcast over at the current location" in the search. Due to this, it is possible to capture broadcast programs of that location in a short time.

### INDUSTRIAL APPLICABILITY

The invention becomes an advantageous means for realizing diverse auto preset operations in a digital broadcast receiving apparatus.

## Claims

1. A broadcast receiving apparatus having an automatic channel selection function unit for searching for broadcast waves,
said broadcast receiving apparatus **characterized in that** said automatic channel selection function unit is able to set a plurality of different channel selection modes and executes automatic channel selection under a channel selection mode selected in accordance with mode selection information from a user.

2. A broadcast receiving apparatus as set forth in claim 1, **characterized in that** said plurality of channel selection modes include a first channel selection mode and second channel selection mode and, when said broadcast waves are digital broadcasts, said first channel selection mode is a channel selection mode searching for only broadcast stations of said digital broadcasts and said second channel selection mode is a channel selection mode searching for not only broadcast stations of said digital broadcasts, but also service IDs provided by said broadcast stations.

3. A broadcast receiving apparatus as set forth in claim 2, **characterized in that** in said first channel selection mode, names of said broadcast stations are successively displayed and the broadcast programs for predetermined representative service IDs among a plurality of service IDs provided by each broadcast station are displayed.

4. A broadcast receiving apparatus as set forth in claim 2, **characterized in that** in said second channel selection mode, names of the broadcast stations are successively displayed and the plurality of service IDs provided by the broadcast stations are successively displayed for each of the successively displayed broadcast stations.

5. A broadcast receiving apparatus as set forth in claim 4, **characterized by** displaying the broadcast program of the first service ID provided by each broadcast station for each of the successively displayed broadcast stations.

6. A broadcast receiving apparatus as set forth in claim 4, **characterized in that** in said second channel selection mode, when successively displaying the names of the broadcast stations and successively displaying the plurality of service IDs provided by each broadcast station for each of the successively displayed broadcast stations, the broadcast program for each displayed service ID is displayed.

7. A broadcast receiving apparatus as set forth in claim 2, **characterized by** being provided with an auto preset memory for storing channel selection information searched for under the first channel selection mode and second channel selection mode.

8. A broadcast receiving apparatus as set forth in claim 2, **characterized by** including a third channel selection mode as one of the said plurality of channel selection modes, which third channel selection mode executing processing for searching for and registering only freely selected broadcast stations among the plurality of broadcast stations of digital broadcasts when the broadcast waves are digital broadcasts and processing for searching for and registering not only said broadcast stations but also the freely selected service IDs among the plurality of service IDs provided by the broadcast stations.

9. A broadcast receiving apparatus as set forth in claim 8, **characterized by** being provided with an auto preset memory storing channel selection information searched for and registered under this third channel selection mode.

10. A broadcast receiving apparatus as set forth in claim 7 or 9, **characterized in that** only channel selection information selected under specific conditions among the retrieved channel selection information are input to the auto preset memory 31.

11. A method of searching for broadcast waves by an automatic channel selection function unit in an broadcast receiving apparatus, said broadcast signal search method **characterized in that** said automatic channel selection function unit
(i) sets a plurality of different channel selection modes,
(ii) selects one of said plurality of channel selection modes in accordance with mode selection information from a user, and
(iii) executes automatic channel selection by said selected channel selection mode.

12. A broadcast signal search method as set forth in claim 11, wherein said plurality of channel selection modes include a first channel selection mode and second channel selection mode and, when said broadcast waves are digital broadcasts, said first channel selection mode is a channel selection mode searching for only broadcast stations of said digital broadcasts and said second channel selection mode is a channel selection mode searching for not only broadcast stations of said digital broadcasts, but also service IDs provided by said broadcast stations.
